(19) Europäisches Patentamt
European Patent Office
Office européen des brevets

(11) **EP 4 462 318 A2**

(12) **EUROPEAN PATENT APPLICATION**

(43) Date of publication:
**13.11.2024  Bulletin 2024/46**

(21) Application number: **24158652.8**

(22) Date of filing: **20.02.2024**

(51) International Patent Classification (IPC):
***G06N 10/40*** *(2022.01)*

(52) Cooperative Patent Classification (CPC):
**G06N 10/40**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **12.05.2023  JP 2023079534**

(71) Applicant: **Hitachi, Ltd.
Tokyo 100-8280 (JP)**

(72) Inventors:
- **NORIMATSU, Takayasu
  Tokyo (JP)**
- **WACHI, Yusuke
  Tokyo (JP)**
- **KANNO, Yusuke
  Tokyo (JP)**

(74) Representative: **Manitz Finsterwald
Patent- und Rechtsanwaltspartnerschaft mbB
Martin-Greif-Strasse 1
80336 München (DE)**

(54) **MICROWAVE PULSE GENERATOR AND QUANTUM COMPUTER**

(57)    The microwave pulse generator 101 consists of a logic circuit 203 that outputs pulse data 213 of a set pulse width and amplitude, a frequency generator 201 that outputs sine waves 211, 212 having the same frequency as the selected quantum bit, a RFDAC 204 that converts pulse data 213 into an analogue signal, modulates it with a sine wave 211 and outputs a signal with the frequency of the sine wave as the center frequency as microwave pulse 111, and a frequency divider 202 that outputs system clock 124 divided by the frequency of sine wave 212. The frequency generator 201 operates at the same frequency as the selected quantum bit except when outputting microwave pulse 111, and the logic circuit 203 operates in synchronization with the system clock 124.

EP 4 462 318 A2

**Description**

BACKGROUND OF THE INVENTION

1. Field of the Invention

The invention relates to a microwave pulse generator that generates phase adjustable microwaves for operating a quantum bit and quantum computer.

2. Description of the Related Art

As the limits of semiconductor miniaturization are becoming visible, we are reaching the limit of relying on semiconductor miniaturization to improve von Neumann-type computers. For this reason, attention is focusing on computers that operate on a different principle than the von Neumann type and that can solve specific problems at high speeds. As one such example, the quantum computer is being developed.

A quantum computer uses information such as energy states of devices that can superimpose states called quantum bits and performs calculations by manipulating the state probabilities of quantum bits. Quantum bits include those that use superconductivity and those that use electron spin. For electron spin, two energy states are used as information.

Electrons are in precessional motion with a certain magnetic moment, and when a strong magnetic field is applied to the electrons from outside, two energy states, upward spin and downward spin, are generated. In this case, the angular frequency of the spin of the electron changes depending on the strength of the magnetic field. During the coherence time, the upward and downward spins are in a superposition state. By applying a radio frequency (RF) field of the same frequency as the angular frequency, the probabilities of the two energy states can be manipulated. When an RF field applied, the two spin state probabilities undergo Rabi oscillations that vary sinusoidally with the energy given. Therefore, it is necessary to control the energy and phase of the RF magnetic field in order to manipulate the two spin state probabilities to the required state probabilities.

The microwave pulse generator, which generates the RF magnetic field by microwave pulse irradiation, uses an IQ modulator to allow phase control as well (see US2018/0013426, US2020/0034736) .

SUMMARY OF THE INVENTION

In the microwave pulse generator of US2018/0013426 and US2020/0034736, the IQ modulator can control the phase by changing the amplitude of RF signals with 90° phase difference. However, the 90° phase difference can be slightly shifted or the signal amplitudes on the I and Q sides can be misaligned, resulting in phase errors. Quantum manipulations are performed several times during the coherence time of a quantum bit. The phase difference between the microwave pulse and the precession of the quantum bit must be kept constant. Therefore, the phase error leads to a degradation of the accuracy of the quantum manipulation.

Because microwave pulses irradiated spatially spread out, multiple quantum bits are operated simultaneously when quantum bits are integrated. Therefore, control is performed so that the angular frequency is changed between the quantum bit to be manipulated and other quantum bits. In this case, the output phase of the microwave pulse generator is also changed by the frequency switch.

In a quantum computer using electron spins, the microwave pulse that performs quantum manipulation needs to minimize the phase error during quantum manipulation while maintaining the phase difference with the quantum bit during the coherence time. Furthermore, the frequency switching during quantum manipulation causes phase shift, which is an issue.

Therefore, the purpose of this invention is to provide a technique that can correct the phase shift due to frequency switching of the microwave pulse while reducing the phase error between the quantum bit and the microwave pulse.

To solve the above problem, one of the typical quantum computers of the present invention is a quantum computer comprising a quantum bit array with multiple quantum bits, a quantum bit selector that selects a quantum bit to be quantum manipulated from the quantum bit array and shifts the angular frequency, and a microwave pulse generator that has the same frequency as the selected quantum bit and outputs a microwave pulse with a set pulse width and pulse amplitude, wherein the microwave pulse generator comprises, a logic circuit that outputs pulse data of the set pulse width and pulse amplitude, a frequency generator that outputs a sine wave having the same frequency as the selected quantum bit, a converter that converts the pulse data into an analog signal, modulates it with the sine wave, and outputs a signal having the frequency of the sine wave as the center frequency as a microwave pulse, and a frequency divider that outputs a system clock divided by the frequency of the sine wave, wherein the frequency generator operates at the same frequency as the quantum bit other than the selected quantum bit except when the microwave pulse is output, and the logic circuit operates in synchronization with the system clock.

According to the present invention, phase shift due to frequency switching of the microwave pulse can be corrected while reducing the phase error between the quantum bit and the microwave pulse.

Issues, configurations and effects other than those described above will be clarified in the following description of embodiments.

BRIEF DESCRIPTION OF THE DRAWINGS

Fig. 1 is a block diagram showing an example of the configuration of a quantum computer in Example 1.
Fig. 2 shows an example of the configuration of the microwave pulse generator 101 in Example 1.
Fig. 3 shows an example of the configuration of frequency generator 201 in Fig. 2.
Fig. 4 shows a first example of the configuration of the logic circuit 203 in Fig. 2.
Fig. 5 shows an example of the operation of the logic circuit 203 in Fig. 4.
Fig. 6 shows an example of the results of simulating the operation shown in Fig. 5.
Fig. 7 shows a second configuration example of the logic circuit 203 in Fig. 2.
Fig. 8 shows an example of the operation of the logic circuit 203 in Fig. 7.
Fig. 9 shows a third configuration example of the logic circuit 203 in Fig. 2.
Fig. 10 shows an example of the operation of the logic circuit 203 in Fig. 9.
Fig. 11 shows another example of the operation of the logic circuit 203 in Fig. 9.
Fig. 12 shows an example of the configuration of a microwave pulse generator 101 in Example 2.
Fig. 13 shows an example of the configuration of a microwave pulse generator 101 in Example 3.
Fig. 14 shows an example of the configuration of the logic circuit 1303 in Fig. 13.
Fig. 15 shows an example of the normal operation of the logic circuit 1303 in Fig. 14.
Fig. 16 shows an example of the operation during calibration of the logic circuit 1303 in Fig. 14.
Fig. 17 shows an example of the configuration of a quantum computer in Example 4.

DETAILED DESCRIPTION OF THE PREFERRED EMBODIMENTS

Examples are described below using the drawings.

[Example 1]

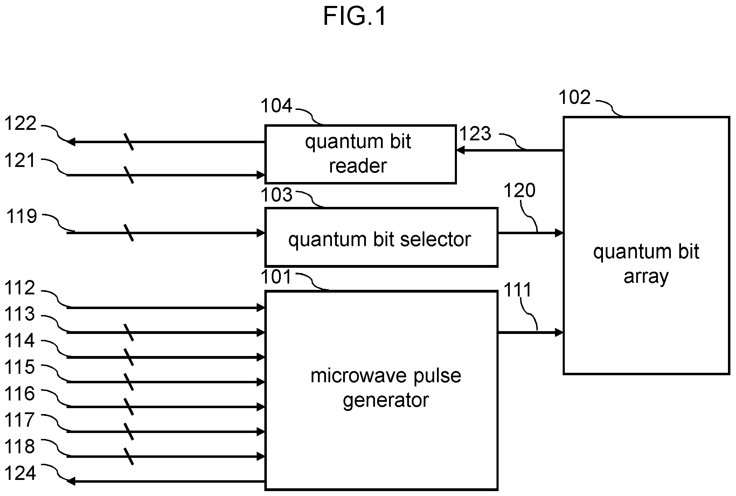

Figure 1 is a block diagram showing an example of the configuration of a quantum computer in Example 1.

The quantum computer comprises a quantum bit array 102 that holds information, a microwave pulse generator 101 that manipulates the quantum bit array 102, a quantum bit selector 103 that selects a quantum bit to be manipulated from the quantum bit array 102, and a quantum bit reader 104 that reads out the result manipulated by the microwave pulse generator 101 from the selected quantum bit in the quantum bit array 102.

The quantum bit array 102 has multiple quantum bits arranged in array form. The quantum bits selected by the quantum bit selection signal 120 are operated by irradiating microwave pulses 111. And the operated quantum bit state 123 is read out by quantum bit reader104.

The microwave pulse generator 101 receives reference clock 112, frequency setting signal 113, pulse trigger signal 114, pulse waveform setting signal 115, pulse width setting signal 116, phase setting signal 117, and frequency offset setting signal 118.

The microwave pulse generator 101 outputs a microwave pulse 111 with a center frequency equal to the sum of the frequency setting signal 113 and the frequency offset setting signal 118, a phase offset set by the phase setting signal 117, and a pulse width set by the pulse width setting signal 116, and a pulse shape that includes an amplitude set by the pulse waveform setting signal 115, at the input timing of the pulse trigger signal 114. ,

The microwave pulse 111 is made to resonate by having a frequency that matches the selected quantum bit, and the state probability of the selected quantum bit is manipulated by the pulse width and pulse amplitude.

The microwave pulse generator 101 also outputs system clock 124, which provides a clock for synchronization to circuits that perform logic operations.

The quantum bit selector 103 receives the quantum bit address signal 119 and outputs the quantum bit selection signal 120 to select the quantum bit to be quantum manipulated from the quantum bit array 102. In doing so, the angular frequency of the quantum bit to be selected is shifted or otherwise made selectable.

The quantum bit reader 104 receives the control signal 121, reads the quantum bit state 123 from the quantum bit array 102, and outputs the quantum bit readout results 122.

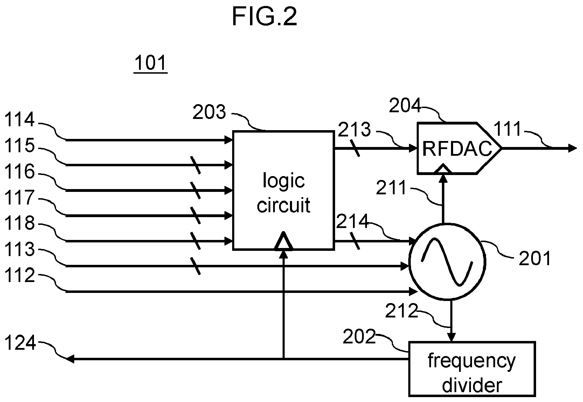

Figure 2 shows an example of the configuration of the microwave pulse generator 101 in Example 1.

The microwave pulse generator 101 has a frequency generator 201, frequency divider 202, logic circuit 203, and RFDAC 204.

The frequency generator 201 receives the reference clock 112, frequency setting signal 113, and frequency modulation signal 214, and outputs sine wave 211 and sine wave 212 with the center frequency and phase set by the frequency setting signal 113 and the frequency generator 201.

The frequency divider 202 outputs a system clock 124 divided by the frequency of the sine wave 212.

The logic circuit 203 operates in synchronization with the system clock 124 and outputs pulse data 213 to the RFDAC 204 based on the pulse waveform setting signal 115 and pulse width setting signal 116 at the rise timing of the pulse trigger signal 114. The logic circuit 203 also outputs modulation signal 214 to frequency generator201 during the period based on signal 116, based on the phase setting signal 117 and frequency offset setting signal 118 at the timing of the pulse trigger signal 114

RFDAC (Radio Frequency Digital to Analog Converter) 204 receives pulse data 213, converts pulse data 213 to an analog signal, modulates it with sine wave 211, and outputs a signal with the frequency of sine wave 211 as the center frequency as microwave pulse 111.

The frequency generator 201 operates at the same frequency as the angular frequencies other than the selected quantum bit except when outputting pulses, and the phase difference is also constant, so that it operates in pseudo-synchronization with the quantum bit.

Since the pulse width is a value determined by the system clock 124, the phase shift caused by the frequency modulation signal 214 can be calculated and cancelled. Therefore, it is possible to restore the original phase difference even when the center frequency of frequency generator 201 is the same as the selected quantum bit and is changed from the angular frequency of the other quantum bit.

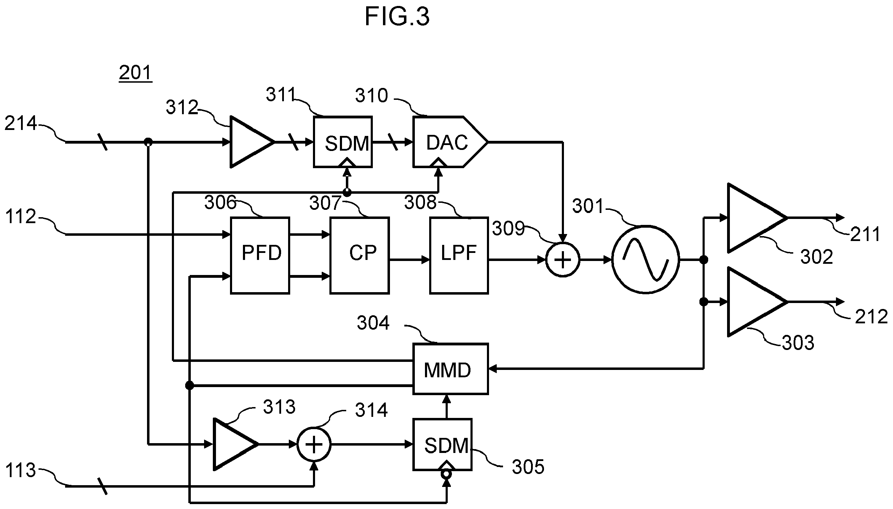

Figure 3 shows an example of the configuration of frequency generator 201 in Figure 2.

The frequency generator 201 is a PLL (Phase Locked Loop) configuration and assumes a 2-point modulation scheme because of the need to switch phases at high speed. In this example, an analog Type 2 PLL is used as an example, but a digital PLL or sub-sampling PLL can also be implemented.

The frequency generator 201 shown in Figure 3 consists of a VCO (Voltage Controlled Oscillator) 301, buffer 302, buffer 303, MMD (Multi Modulus Divider) 304, SDM (Sigma Delta Modulator) 305, PFD (Phase Frequency Detector) 306, CP (Charge Pump) 307, LPF (Low Pass Filter) 308, adder 309, DAC (Digital to Analog Converter) 310, SDM (Sigma Delta Modulator) 311, gain adjustment 312, gain adjustment 313, and adder 314.

The frequency modulation signal 214 is divided into two paths. One path performs gain adjustment to cancel the gain of VCO 301 by the gain adjustment 312, and concerts the signal modulated by SDM 311 to a voltage by DAC 310, and then modulates the frequency of VCO 301 through adder 309 . In the other path, after adjusting the gain with gain adjustment 313, the signal is added to the frequency setting signal 113 with adder 314, and the signal modulated with SDM 305 is input to MMD 304 to modulate the frequency by changing the frequency divider.

The PLL operates as follows: VCO 301 oscillates at a frequency corresponding to the input voltage, the output of VCO 301 is divided by MMD 304, and PFD 306 compares the phase between the reference clock 112 and the result divided by MMD 304 to output a signal to increase or decrease the voltage. The CP 307 can either draw in or draw out current based on the signal from the PFD 306. LPF 308 suppresses the high-frequency component of the CP 307 signal to make it a stable voltage and supplies it to VCO 301.

Since the reference clock 112 and the clock divided by MMD 304 are in phase, the output frequency of VCO 301 is locked to a fractional multiple of the frequency of reference clock 112. Sine wave output from VCO 301 is output as sine wave211 via buffer 302 and output as sine wave 212 through buffer 303.

Next, for 2-point modulation, since the path through DAC 310 passes only high-frequency components and the path through SDM 305 passes only low-frequency components, if the timing and gain of these two paths can be matched, frequency modulation signal 214 will be an all-path characteristic for the VCO 301 output, and a sine wave with the set phase and offset frequency can be obtained.

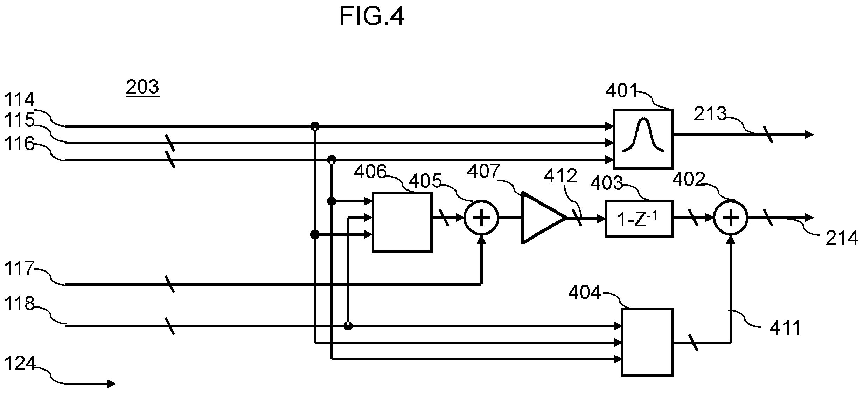

Figure 4 shows a first configuration example of the logic circuit 203 in Figure 2.

Since frequency modulation signal 214 changes the output frequency of frequency generator 201, it shifts the phase difference between the frequency generator 201 and a group of quantum bits that are not selected. Therefore, logic circuit 203 has a mechanism to cancel the phase shift caused by the frequency offset.

The logic circuit 203 has a pulse waveform data generator 401, adder 402, differentiator 403, frequency offset controller 404, adder 405, phase shift compensator 406, and gain adjustment 407, and operates in synchronization with the system clock 124.

The pulse waveform data generator 401 outputs the pulse waveform data set by the pulse waveform setting signal 115 and the pulse width setting signal 116 by triggering the timing when the pulse trigger signal 114 goes High.

The phase shift compensator 406 calculates the amount of phase shift based on the pulse width setting signal 116 and frequency offset setting signal 118, and outputs a phase cancel signal after a delay of pulse width +α from the pulse trigger signal 114.

adder 405 adds the phase cancellation signal output by phase shift compensator 406 to phase setting signal 117. Gain adjustment 407 adjusts the gain of the phase value resulting from the addition by adder 405 and outputs gain adjustment output 412.

Differentiator 403 calculates the difference between gain adjustment output 412. Adder 402 adds the result of calculation of differentiator 403 and the frequency offset 411 output by the frequency offset controller 404, and output frequency modulation signal 214.

The frequency offset controller 404 outputs the frequency offset setting signal 118 by triggering the timing of the pulse trigger signal 114, and outputs it for the pulse width period set by the pulse width setting signal, and is set to 0 otherwise.

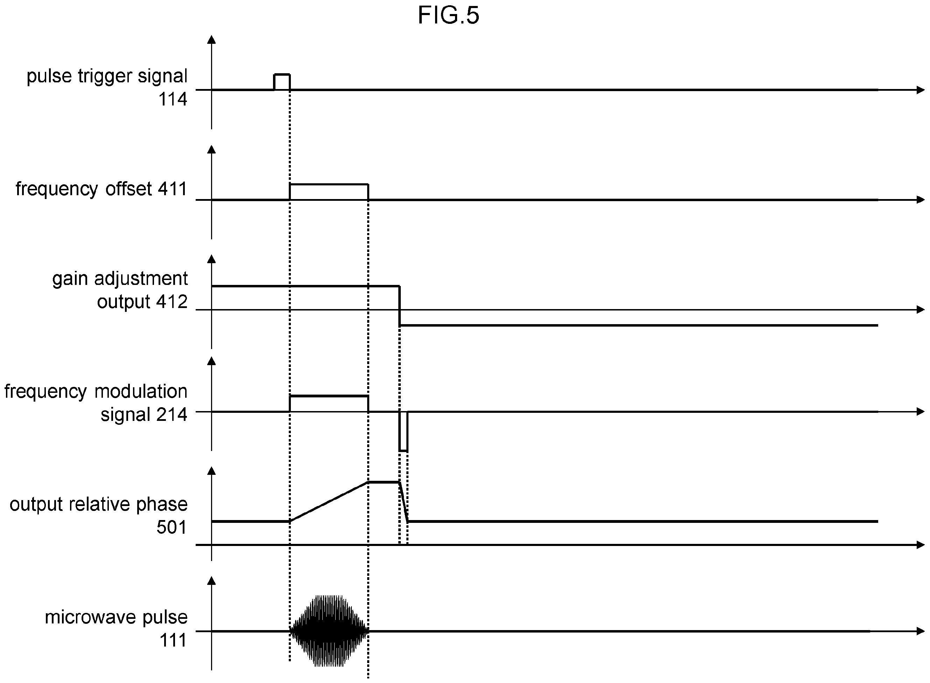

Figure 5 shows an example of the operation of the logic circuit 203 in Figure 4.

The frequency offset controller 404 outputs frequency offset 411 for the pulse width by triggering pulse trigger signal 114. The gain adjustment output 412 switches to the value to which the phase shift correction is added with a delay of the pulse width $+\alpha$. Therefore, frequency modulation signal 214 outputs the value set by frequency offset 411 at first, and then outputs the differential value of gain adjustment output 412.

At this time, the output phase of frequency generator 201 is changed and then cancelled to the original phase, as in output relative phase 501 to the frequency set by frequency setting signal 113.

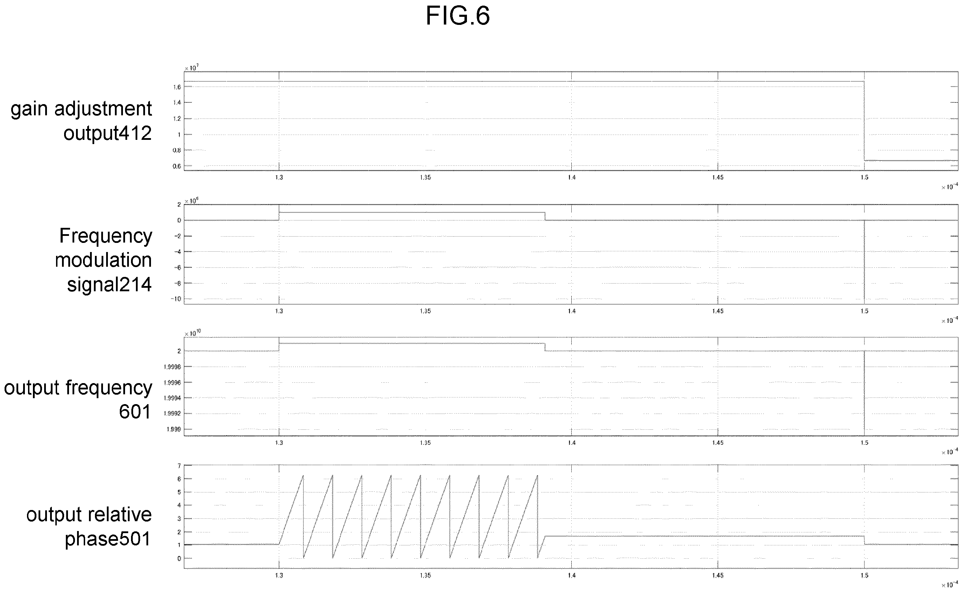

Figure 6 shows an example of the results of simulating the operation of Figure 5.

The frequency modulation signal 214 output from adder 402 initially outputs the frequency of frequency offset 411, and the difference is output when gain adjustment output 412 is switched. At this time, output frequency 601 of frequency generator 201 is the value obtained by adding frequency setting signal 113 to frequency modulation signal 214. Output relative phase 501 is fixed at a certain value after the pulse output, but phase correction is added and the phase returns to the phase before the pulse output.

According to the first configuration example of logic circuit 203 described in Figures 4 to 6, the phase shift compensator 406 calculates the amount of phase shift based on the pulse width setting signal 116 and frequency offset setting signal 118, outputs the phase cancel signal after a delay of pulse width $+\alpha$ from the pulse trigger signal 114, and adds it to the phase setting signal 117 at the adder 405. This enables correction of phase shift due to frequency switching of the microwave pulse while reducing the phase error between the quantum bit and the microwave pulse.

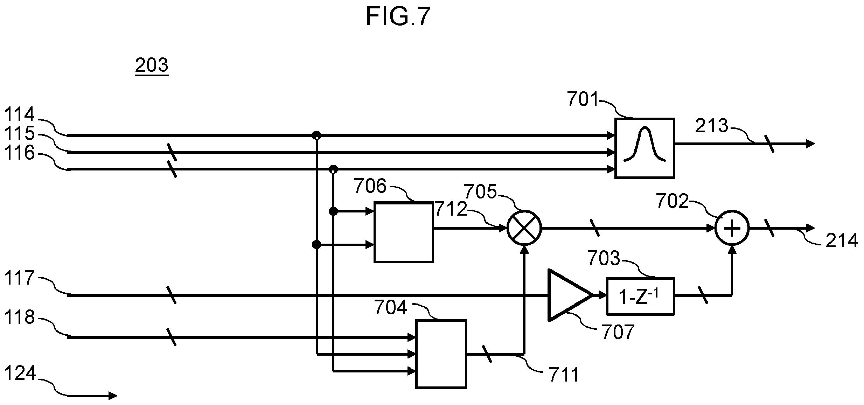

Figure 7 shows a second configuration example of the logic circuit 203 in Figure 2.

This method cancels phase shift by outputting two pulses and inverting the frequency offset of each pulse to be positive or negative.

The logic circuit 203 in Fig. 7 has a pulse waveform data generator 701, adder 702, differentiator 703, frequency offset controller 704, multiplier 705, frequency offset positive/negative switch706, and gain adjustment 707, and operates in synchronization with the system clock 124.

The pulse waveform data generator 701 outputs the pulse waveform data set by the pulse waveform setting signal 115 and the pulse width setting signal 116 by triggering the timing when the pulse trigger signal 114 goes High.

The frequency offset controller 704 calculates the output period from the first pulse to the end of the second pulse based on the pulse width setting signal 116, triggers the pulse trigger signal 114, outputs the frequency offset setting signal 118 as frequency offset signal 711 during the output period, and outputs 0 during the other periods.

The frequency offset positive/negative switch 706 calculates the positive and negative output periods based on the pulse width setting signal 116, and triggers the pulse trigger signal 114 to output the positive signal of positive/negative signal 712 during the positive period and the negative signal of positive/negative signal 712 during the negative output period.

Multiplier 705 multiplies frequency offset signal 711 and frequency offset positive/negative signal 712 and outputs it to adder 702.

The adder 702 adjusts the gain of the phase setting signal 117 using gain adjustment 707 and adds the differential value taken by differentiator 703 to the output of adder 702 to produce frequency modulation signal 214.

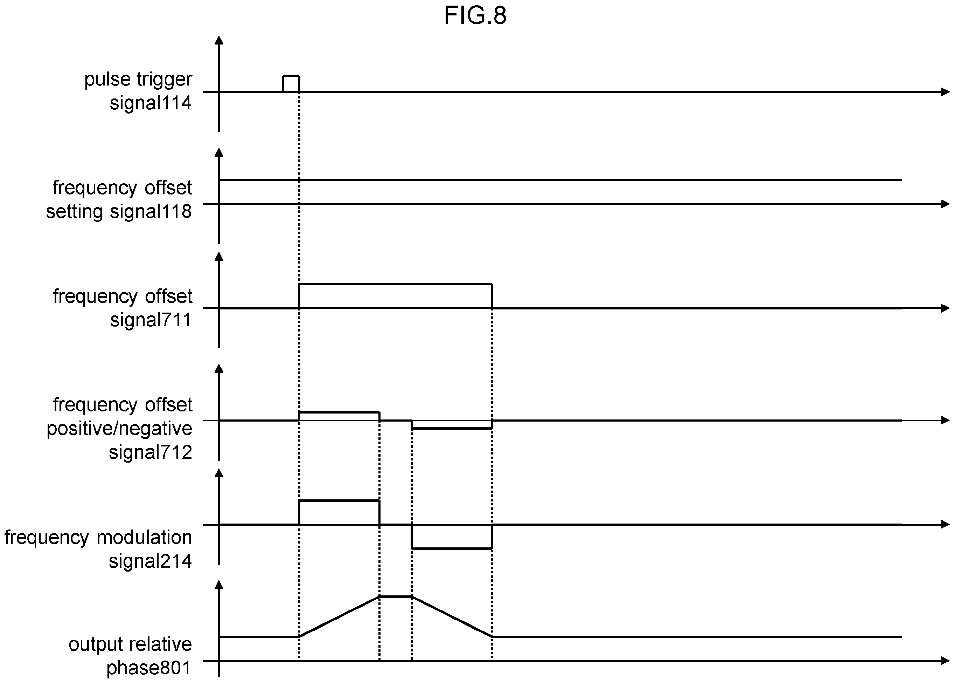

Figure 8 shows an example of the operation of the logic circuit 203 in Figure 7.

The frequency offset controller 704 receives a constant value of frequency offset setting signal 118, triggers pulse trigger signal 114, and outputs frequency offset signal 711 with a width of 2 pulses.

The frequency offset positive/negative switch 706 outputs a frequency offset positive/negative signal 712, which is a positive signal during the first pulse width period and a negative signal during the next pulse width period.

The frequency modulation signal 214 has the same width of alternating positive and negative offset frequencies. Therefore, the output relative phase 801 of frequency generator 201 rises and falls during the same period and is equivalent to the phase before the pulse output.

According to the second configuration example of logic circuit 203 described in Figures 7 and 8, frequency offset positive/negative switch 706 calculates positive and negative output periods based on pulse width setting signal 116, triggers pulse trigger signal 114, and outputs frequency offset positive/negative signal 712 of a positive signal in the positive output period and a negative signal in the negative output period. This allows phase shift due to frequency switching of the microwave pulse to be corrected while reducing the phase error between the quantum bit and the microwave pulse.

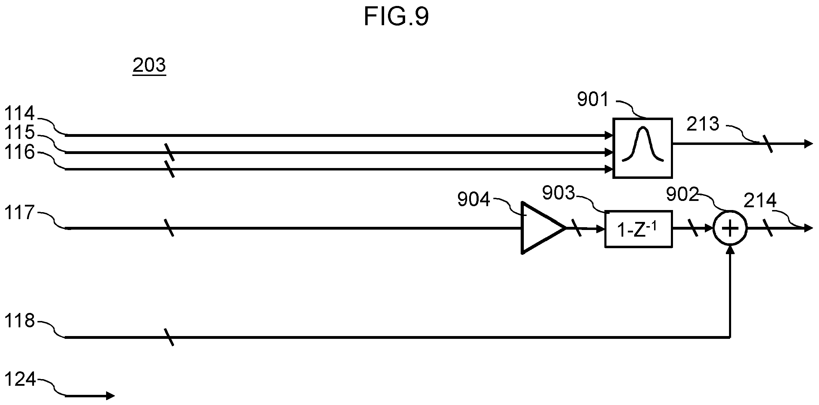

Figure 9 shows a third configuration example of the logic circuit 203 in Figure 2.

In the third example, the logic circuit 203 does not have a circuit that controls the signal, but instead switches the setting signal pulse by pulse with a microprocessor or control logic circuit outside the logic circuit 203.

The logic circuit 203 in Figure 9 has a pulse waveform data generator 901, adder 902, differentiator 903, and gain adjustment 904.

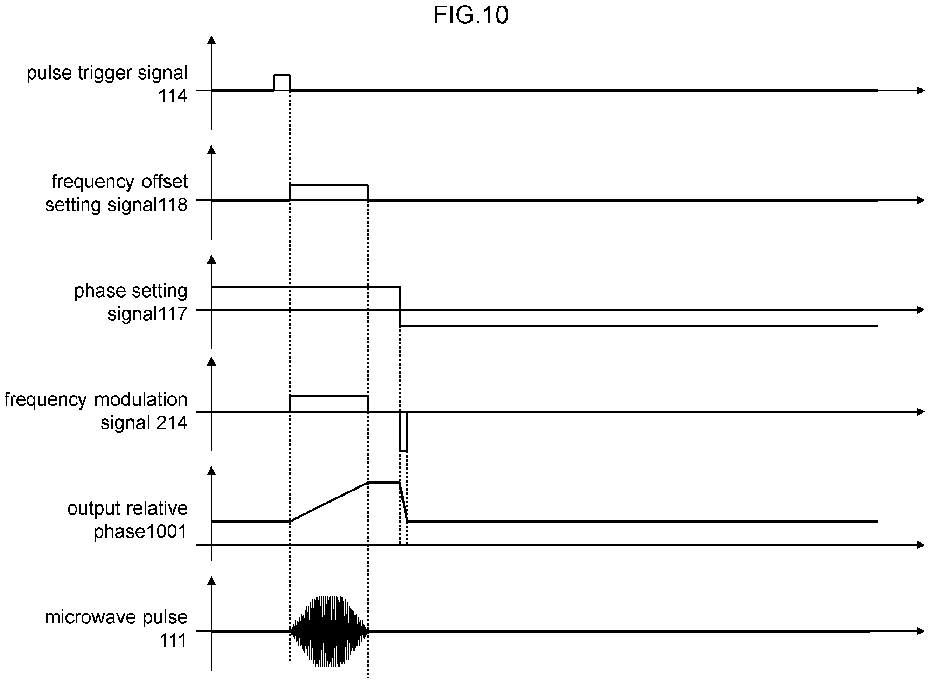

Figure 10 shows the waveforms when the configuration in Figure 9 is made to operate in the same manner as the configuration in Figure 4.

Figure 10 shows an example of the operation of the logic circuit 203 in Figure 9.

A microprocessor or control logic circuit external to logic circuit 203 triggers pulse trigger signal 114 to set frequency offset setting signal 118 to the desired frequency offset value for the pulse width period. The phase setting signal 117 is changed after the pulse width period so that the phase returns to the same value as before the pulse output.

The frequency modulation signal 214 is determined by the frequency offset setting signal 118 and the phase setting signal 117. Therefore, the output relative phase 1001 to the frequency determined by the frequency setting signal 113 of frequency generator 201 is changed by the frequency offset setting signal 118, but the phase setting signal 117 cancels it and returns to the same phase as before the pulse output.

According to the example in Fig. 10, a microprocessor, control logic circuit, or the like external to logic circuit 203 triggers pulse trigger signal 114 to set frequency offset setting signal 118 to the desired frequency offset value for the pulse width period. The phase setting signal 117 is changed after the pulse width period so that the phase returns to the same value as before the pulse output. This allows phase shift due to frequency switching of the microwave pulse to be corrected while reducing the phase error between the quantum bit and the microwave pulse.

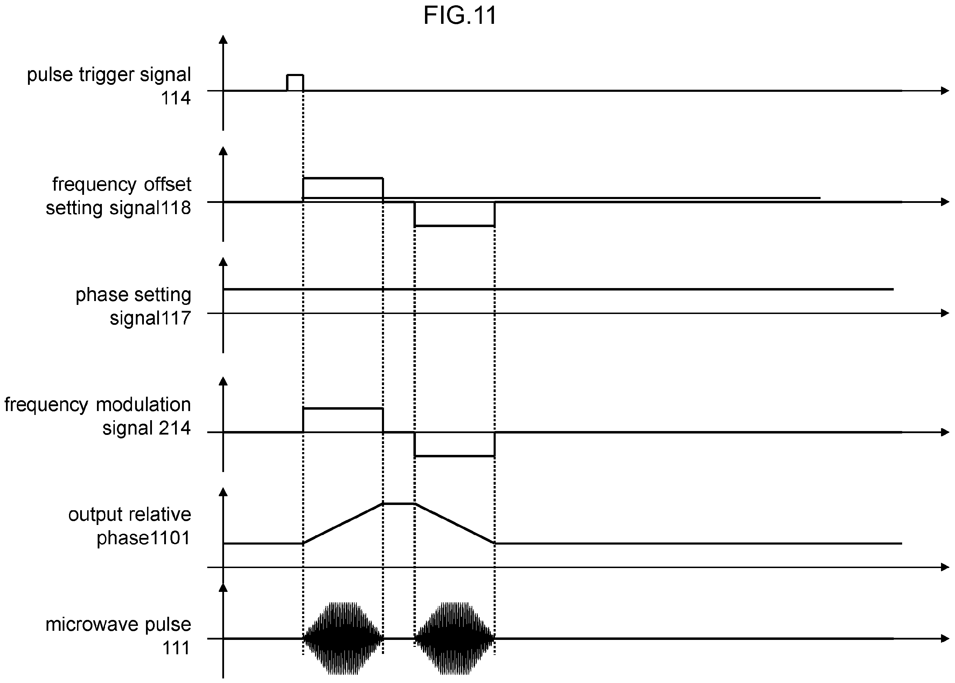

Figure 11 shows the waveforms when the configuration in Figure 9 is made to operate in the same manner as the configuration in Figure 8.

Figure 11 shows another example of the operation of the logic circuit 203 in Figure 9.

A microprocessor or control logic circuit external to logic circuit 203 triggers pulse trigger signal 114 and outputs frequency offset setting signal 118 with positive and negative pulses for the first and second pulses, and cancels phase shift due to frequency offset. For example, if the frequency offset is positive for the first pulse, the absolute value is the same for the second pulse but negative.

This changes the output relative phase 1101 after the first pulse output, but returns to the phase before the first pulse output after the second pulse output.

According to the example in Figure 11, a microprocessor, control logic circuit, etc. external to the logic circuit 203 triggers pulse trigger signal 114 and outputs frequency offset setting signal 118 with the first and second pulse reserved positive and negative. This allows phase shift due to frequency switching of the microwave pulse to be corrected while reducing the phase error between the quantum bit and the microwave pulse.

[Example 2]

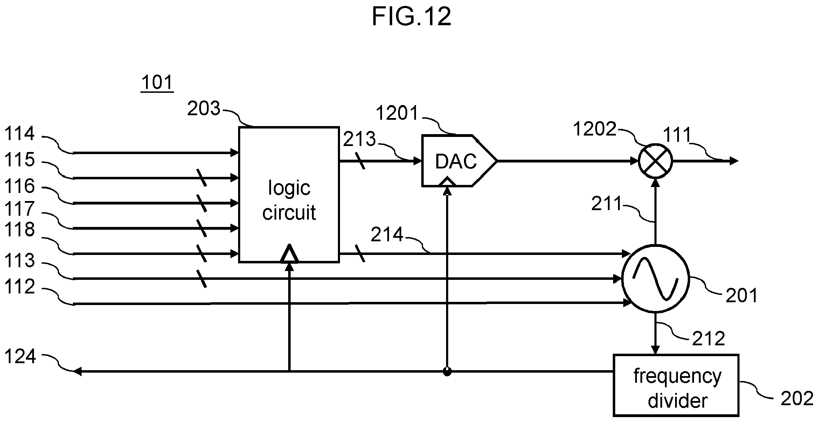

Figure 12 shows an example of the configuration of microwave pulse generator 101 in Example 2.

The microwave pulse generator 101 in Example 2 does not require the use of a high-speed DAC and is easier to design than the microwave pulse generator 101 of Example 1 in Figure 2.

The microwave pulse generator 101 in Figure 12 has a frequency generator 201, frequency divider 202, logic circuit 203, DAC 1201, and mixer 1202.

DAC 1201 operates in synchronization with system clock 124, receives pulse data 213, converts it into an analog signal, and outputs it.

The mixer 1202 modulates the analog signal output by the DAC 1201 with sine wave 211 and outputs a signal having the frequency of sine wave 211 as the center frequency as microwave pulse 111.

The configuration other than DAC 1201 and mixer 1202 is the same as in Figure 2, and the operation is equivalent to Example 1.

According to Example 2, the design is easier because the microwave pulse generator 101 has a DAC 1201 and a mixer 1202 instead of a high-speed DAC. In addition, since a high-speed DAC is not used, power consumption can be reduced.

[Example 3]

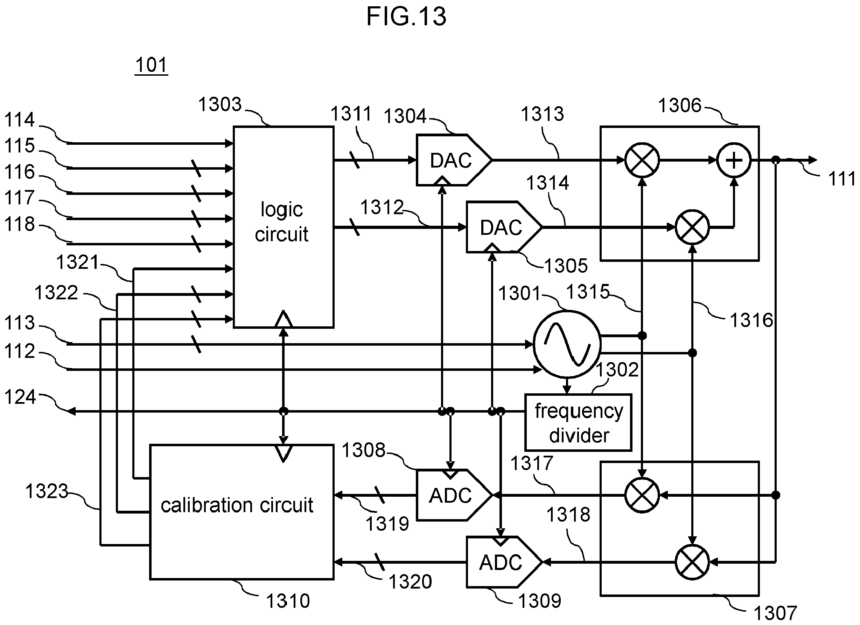

Figure 13 shows an example of the configuration of microwave pulse generator 101 in Example 3.

Example 3 shows an example of using an IQ modulation scheme instead of a polar modulation scheme as in Examples 1 and 2.

In the third example, the frequency generator 1301 does not need to perform phase cancellation because the frequency is always the same as the quantum bit that is not selected. However, since the number of blocks is large, power consumption is larger than in Examples 1 and 2. In addition, phase errors are caused by IQ imbalance, so IQ imbalance calibration is required.

Therefore, in Example 3, the microwave pulse generator 101 has a frequency generator 1301, frequency divider 1302, logic circuit 1303, I-side DAC 1304, Q-side DAC 1305 IQ modulator 1306, IQ demodulator 1307, I-side ADC 1308, Q-side ADC 1309, and calibration circuit 1310.

The frequency generator 1301 is assumed to be a PLL (Phase Locked Loop) circuit. Frequency generator 1301 generates the frequency output set by frequency setting signal 113 in accordance with reference clock 112. The frequency generator 1301 provides LO output sine wave 1315 and LO output cosine wave 1316 with a 90° phase difference to IQ modulator 1306 and IQ demodulator 1307.

The frequency divider 1302 receives the output of the frequency generator 1301, divides the frequency, and generates the system clock 124.

The logic circuit 1303 operates in synchronization with the system clock 124 and generates cosine and sine waves with the phase and frequency set by the phase setting signal 117 and frequency offset setting signal 118 at the rise timing of the pulse trigger signal 114. The cosine and sine wave is multiplied by the pulses set by the pulse waveform setting signal 115 and pulse width setting signal 116, respectively. And then the I modulation data 1311 is output to the I-side DAC 1304, and Q modulation data 1312 is output to the Q-side DAC 1305, respectively.

Both I-side DAC 1304 and Q-side DAC 1305 receive I modulation data 1311 and Q modulation data 1312 from logic circuit 1303 at the timing of system clock 124, convert them to analog values, and output them to IQ modulator 1306.

IQ modulator 1306 multiplies I modulation signal 1313 output by I-side DAC 1304 and Q modulation signal 1314 output by Q-side DAC 1305 with LO output sine wave 1315 and LO output cosine wave 1316 of frequency generator 1301, which have 90° phase difference from each other, respectively, and outputs a phase-modulated microwave pulse 111.

IQ demodulator 1307 multiplies microwave pulse 111 with LO output sine wave 1315 and LO output cosine wave 1316 to demodulate I demodulation signal 1317 and Q demodulation signal 1318. I-side ADC 1308 demodulates I demodulation signal 1317 to I demodulation data 1319 and Q-side ADC 1309 demodulates Q demodulation signal 1318 to Q demodulation data 1320 from analog to digital data.

The calibration circuit 1310 controls the logic circuit 1303 to set the phase setting signal for calibration 1322, obtains I demodulation data 1319 and Q demodulation data 1320 and calculates IQ gain error and phase error and outputs IQ correction data 1323 to logic circuit 1303.

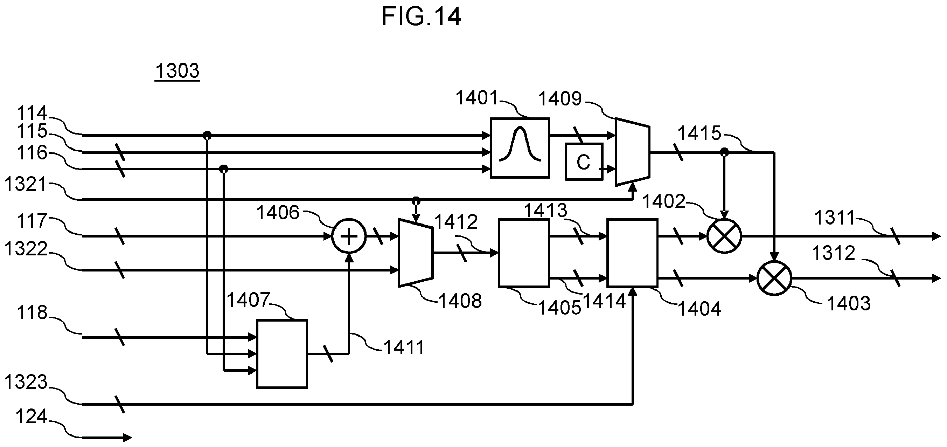

Figure 14 shows an example of the configuration of the logic circuit 1303 in Figure 13.

The microwave pulse generator 101 has a pulse waveform data generator 1401, selector 1409, multiplier 1402, multiplier 1403, IQ imbalance compensator 1404, cosine/sine table 1405, selector 1408, adder 1406, and frequency/phase converter 1407.

The frequency/phase converter 1407 triggers the pulse trigger signal 114 and converts the frequency offset setting signal 118 to the period specified by the pulse width setting signal 116. Adder 1406 adds the phase 1411 and the phase setting signal 117.

Selector 1408 passes the phase setting signal for calibration 1322 as phase data 1412 during the calibration period by calibration control signal 1321, and passes the addition result of adder 1406 as phase data 1412 outside the calibration period.

The cosine/sine table 1405 converts phase data 1412 into cosine wave data 1413 and sine wave data 1414.

IQ imbalance compensator 1404 corrects and outputs cosine wave data 1413 and sine wave data 1414 using IQ correction data 1323.

The pulse waveform data generator 1401 generates pulse waveform data based on the pulse waveform setting signal 115 and pulse width setting signal 116, triggered by the pulse trigger signal 114.

Selector 1409 outputs a fixed value during the calibration period defined by calibration control signal 1321, and outputs pulse waveform data 1415 generated by pulse waveform data generator 1401 during the rest of the calibration period.

The pulse waveform data 1415 is multiplied by the cosine wave data 1413 corrected by multiplier 1402 and the sine wave data 1414 corrected by multiplier 1403, and output as I modulation data 1311 and Q modulation data 1312, respectively.

Next, the operation of the calibration circuit 1310 is described. If the phase to be set is $\Phi$, the phase shift between LO output sine wave 1315, LO output cosine wave 1316 and I modulation signal 1313, Q modulation signal 1314 is $\theta$, the angular frequency of the LO output signal is $\omega$, and the amplitude of the IQ is A, the gain error between the IQs is $\Delta A$, the error from the 90° phase of the LO output is $\Delta\theta$, the I modulation signal 1313 is represented by Formula 1 and the Q modulation signal 1314 by Formula 2.

LO output cosine wave 1316 is represented by Formula 3, LO output sine wave 1315 by Formula 4, and microwave pulse 111 by Formula 5. If the phase difference of LO output cosine wave 1316 and LO output sine wave 1315 between IQ modulator 1306 and IQ demodulator 1307 is $\triangle D$, I demodulation signal 1317 is represented by Formula 6 and Q demodulation signal 1318 by Formula7.

[Formula 1]

$$V_{BBI} = A \cdot \cos(\phi)$$

[Formula 2]

$$V_{BBQ} = (A + \Delta A) \cdot \sin(\phi)$$

[Formula 3]

$$V_{LOI} = \cos(\omega t + \theta)$$

[Formula 4]

$$V_{LOQ} = \sin(\omega t + \theta + \Delta \theta)$$

[Formula 5]

$$V_{RF} = A \cdot \sin(\omega t + \theta + \Delta \theta) \cdot \cos(\phi) + (A + \Delta A) \cdot \cos(\omega t + \theta) \cdot \sin(\phi)$$

[Formula 6]

$$
\begin{aligned}
V_{RI} &= \{A \cdot \sin(\omega t + \theta + \Delta\theta) \cdot \cos(\phi) + (A + \Delta A) \cdot \cos(\omega t + \theta) \cdot \sin(\phi)\} \\
&\quad * \sin(\omega t + \theta + \Delta\theta + \Delta D) \\
&= \frac{A}{2} \cdot \{\cos(\Delta D) - \cos(2\omega t + 2\theta + 2\Delta\theta)\} \cdot \cos(\phi) \\
&\quad + \frac{(A + \Delta A)}{2} \cdot \{\sin(\Delta\theta + \Delta D) + \sin(2\omega t + 2\theta + \Delta\theta + \Delta D)\} \cdot \sin(\phi) \\
&\approx \frac{A}{2} \cdot \cos(\Delta D)\cos(\phi) + \frac{(A + \Delta A)}{2} \cdot \sin(\Delta\theta + \Delta D) \cdot \sin(\phi)
\end{aligned}
$$

[Formula 7]

$$V_{RQ} = \{A \cdot sin(\omega t + \theta + \Delta\theta) \cdot cos(\phi) + (A + \Delta A) \cdot cos(\omega t + \theta) \cdot sin(\phi)\}$$
$$* cos(\omega t + \theta + \Delta D)$$
$$= \frac{A}{2} \cdot \{sin(\Delta\theta - \Delta D) + sin(2\omega t + 2\theta + \Delta\theta)\} \cdot cos(\phi)$$
$$+ \frac{(A + \Delta A)}{2} \cdot \{cos(\Delta D) + cos(2\omega t + 2\theta)\} \cdot sin(\phi)$$
$$\approx \frac{A}{2} \cdot sin(\Delta\theta - \Delta D) \cdot cos(\phi) + \frac{(A + \Delta A)}{2} \cdot cos(\Delta D) \cdot sin(\phi)$$

Consider I demodulation signal 1317 and Q demodulation signal 1318 at $\phi$=0 and $\phi$=$\pi$/2. I demodulation signal 1317 at $\phi$=0 is in Formula 8, Q demodulation signal 1318 at $\phi$=0 is in Formula 9, I demodulation signal 1317 at $\phi$=$\pi$/2 is in Formula 10, and Q demodulation signal 1318 at $\varphi$=$\pi$/2 is in Formula 11.

[Formula 8]

$$V_{RI}(\phi = 0) \approx \frac{A}{2} \cdot cos(\Delta D)$$

[Formula 9]

$$V_{RQ}(\phi = 0) \approx \frac{A}{2} \cdot sin(\Delta\theta - \Delta D) = \frac{A}{2} \cdot \{sin(\Delta\theta)cos(\Delta D) - cos(\Delta\theta)sin(\Delta D)\}$$

[Formula 10]

$$V_{RQ}\left(\phi = \frac{\pi}{2}\right) \approx \frac{A}{2} \cdot sin(\Delta\theta - \Delta D)$$
$$= \frac{A}{2} \cdot \{sin(\Delta\theta)cos(\Delta D) - cos(\Delta\theta)sin(\Delta D)\}$$

[Formula 11]

$$V_{RQ}\left(\phi = \frac{\pi}{2}\right) \approx \frac{(A + \Delta A)}{2} \cdot cos(\Delta D)$$

From Formula 8 to Formula 11, the gain error $\triangle$A and phase error $\triangle\theta$ are obtained in Formula 12 and Formula 13.

[Formula 12]

$$\frac{A}{A + \Delta A} = \frac{V_{RI}(\phi = 0)}{V_{RQ}\left(\phi = \frac{\pi}{2}\right)}$$

[Formula 13]

$$\sin(\Delta\theta) = \left\{ V_{RQ}(\phi=0) + V_{RI}\left(\phi=\frac{\pi}{2}\right) \cdot \frac{V_{RI}(\phi=0)}{V_{RQ}\left(\phi=\frac{\pi}{2}\right)} \right\} \cdot \frac{1}{2 \cdot V_{RI}(\phi=0)}$$

$$= \frac{V_{RQ}(\phi=0)}{2 \cdot V_{RI}(\phi=0)} + \frac{V_{RI}\left(\phi=\frac{\pi}{2}\right)}{2 \cdot V_{RQ}\left(\phi=\frac{\pi}{2}\right)}$$

The IQ imbalance compensator 1404 outputs the cosine wave data 1413 as it is, and the sine wave data side can be corrected by adding the cosine wave data 1413 multiplied by Formula 14 and the sine wave data 1414 multiplied by Formula 15.

[Formula 14]

$$X = -sin(\Delta\theta) \cdot \frac{A}{A + \Delta A}$$

[Formula 15]

$$Y = cos(\Delta\theta) \cdot \frac{A}{A + \Delta A}$$

Considering the influence of DC offset, I demodulation data 1319 and Q demodulation data 1320 are obtained and averaged for $\Phi$ = 0° , 90° , 180° , and 270° , and the difference between $\phi$ = 0° and $\phi$ = 180° is treated as the result of Formula 8 and Formula 9, the difference between $\varphi$=90° and $\varphi$=90° is treated as the result of Formula 10 and Formula 11.

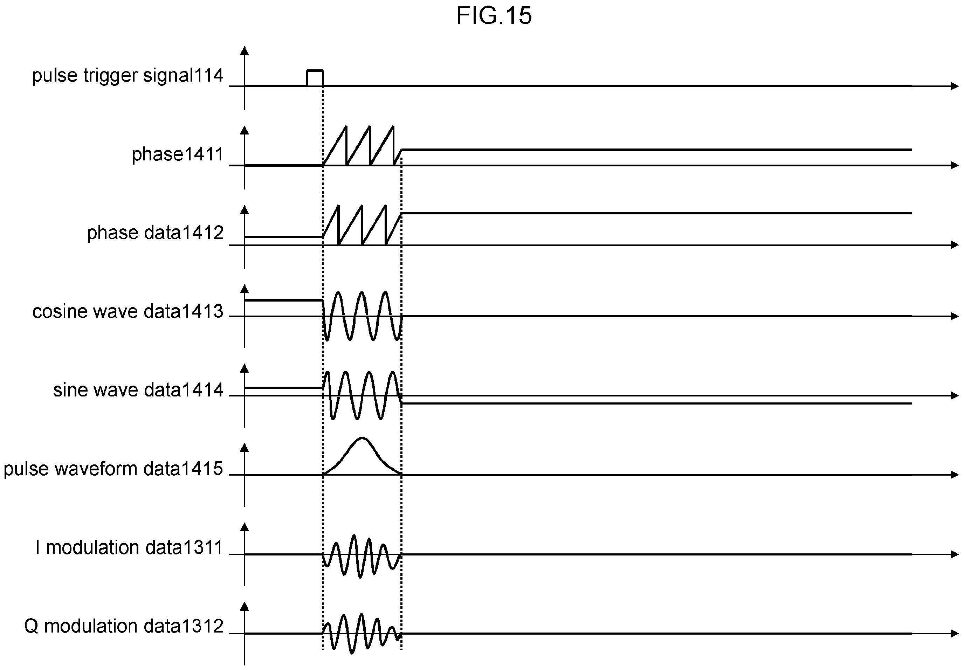

Figure 15 shows an example of the normal operation of the logic circuit 1303 in Figure 14.

After the pulse trigger signal 114 rises, the frequency offset setting signal 118 changes the phase 1411 output by the frequency/phase converter 1407. Phase1411 is added to phase setting signal 117 by adder 1406, and phase data 1412 is output by selector 1408.

Cosine wave data 1413 and sine wave data 1414 are generated from phase data 1412 by cosine/sine table 1405 and multiplied with pulse waveform data 1415 by multipliers 1402 and 1403, I modulation data 1311 and Q modulation data 1312 are output respectively.

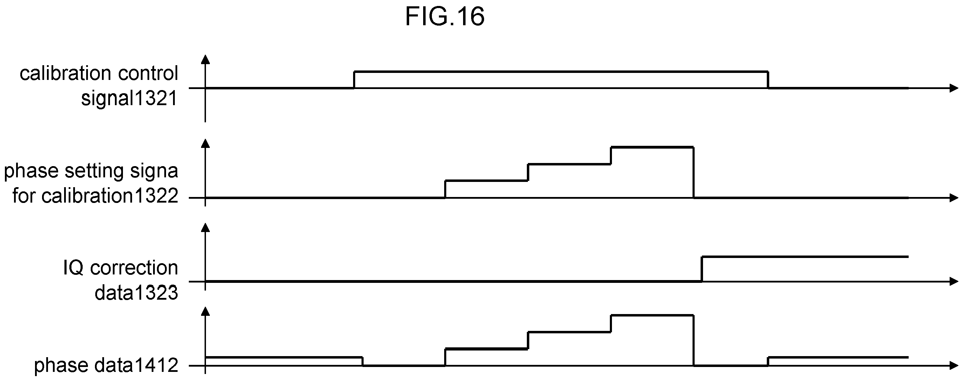

Figure 16 shows an example of the operation of the logic circuit 1303 in Figure 14 during calibration.

In the calibration circuit 1310, calibration is performed while the calibration control signal 1321 is High, with the phase setting signal for calibration 1322 changed to 0° , 90° , 180° , 270° , and IQ correction data 1323 is finally calculated and output.

According to Example 3, calibration circuit 1310 acquires I demodulation data 1319 and Q demodulation data 1320, calculates IQ gain error and phase error, and outputs IQ correction data to logic circuit 1303. IQ imbalance compensator 1404 uses IQ correction data 1323 to correct cosine wave data 1413 and sine wave data 1414 and output them. This reduces the phase error between the quantum bit and the microwave pulse.

[Example 4]

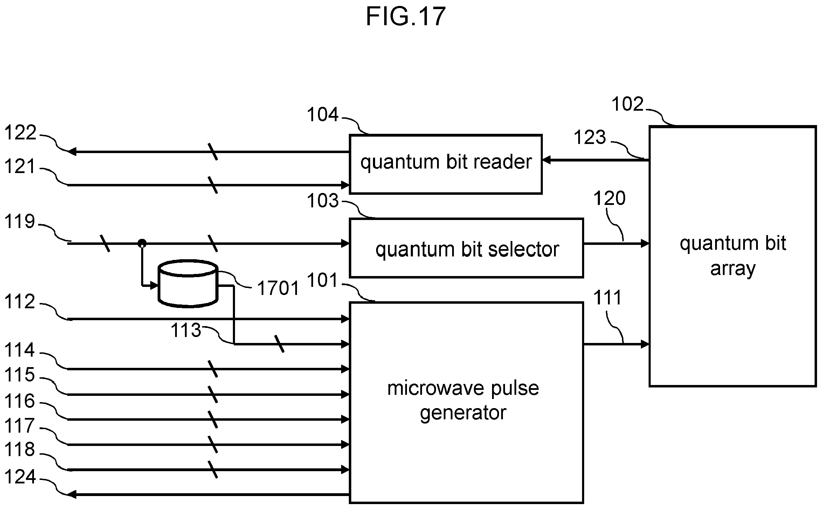

Figure 17 shows an example of the quantum computer configuration in Example 4.

In Example 4, when there is a small frequency shift between the quantum bits in the quantum bit array, data to correct the phase shift caused by the frequency shift is added to microwave pulse 111 and output.

The quantum computer in Figure 17 has phase correction data 1701 in addition to the configuration in Figure 1. Quantum bit address signal 119 is put into phase correction data 1701, and then phase correction is added, frequency setting signal 113 is input to the microwave pulse generator 101.

The microwave pulse generator 101 has the same configuration as in Figure 2. Frequency generator 201 outputs a sine wave based on the phase-corrected frequency setting signal 113. RFDAC 204 modulates pulse data 213 by the sine wave 211 and outputs a signal with the frequency of the sine wave 211 as the center frequency as microwave pulse111.

According to Example 4, the quantum bit address signal 119 is put into the phase correction data 1701, phase correction is added, and the frequency setting signal 113 is input to the microwave pulse generator 101. This allows correction of minute frequency deviations between the quantum bits in the quantum bit array.

The present invention is not limited to the above examples, but includes various variations. For example, the above examples are described in detail for the purpose of explaining the invention in an easy-to-understand manner, and are not necessarily limited to those having all the described configurations. It is also possible to replace a part of the configuration of one example with that of another example, and it is also possible to add the configuration of another example to that of one example. It is also possible to add, delete, or replace some of the configurations of each example with other configurations.

**Claims**

1. A quantum computer, comprising:

   a quantum bit array with multiple quantum bits,
   a quantum bit selector that selects a quantum bit to be quantum manipulated from the quantum bit array and shifts the angular frequency, and
   a microwave pulse generator that has the same frequency as the selected quantum bit and outputs a microwave pulse with a set pulse width and pulse amplitude,
   wherein the microwave pulse generator comprises,
   a logic circuit that outputs pulse data of the set pulse width and pulse amplitude,
   a frequency generator that outputs a sine wave having the same frequency as the selected quantum bit,
   a converter that converts the pulse data into an analog signal, modulates it with the sine wave, and outputs a signal having the frequency of the sine wave as the center frequency as a microwave pulse, and
   a frequency divider that outputs a system clock divided by the frequency of the sine wave,
   wherein the frequency generator operates at the same frequency as the quantum bit other than the selected quantum bit except when the microwave pulse is output, and
   the logic circuit operates in synchronization with the system clock.

2. The quantum computer according to claim 1,

   wherein the logic circuit outputs a frequency modulation signal based on the frequency of the selected quantum bit, and
   the frequency generator outputs a sine wave based on the frequency modulation signal.

3. The quantum computer according to claim 2,
   wherein the logic circuit calculates the amount of phase shift based on the set pulse width and the frequency of the selected quantum bit, and outputs a frequency modulation signal based on the amount of phase shift.

4. The quantum computer according to claim 2,
   wherein the logic circuit outputs a frequency modulation signal based on the frequency of the selected quantum bit, and then outputs a frequency modulation signal based on the frequency of the selected quantum bit multiplied by a negative value.

5. The quantum computer according to claim 2,
   wherein the logic circuit acquires the phase setting signal, which is the set phase minus the phase shift amount, from an external source, and outputs a frequency modulation signal based on the acquired phase setting signal.

6. The quantum computer according to claim 2,
   wherein the logic circuit acquires from an external source the frequency offset setting signal of the frequency of the selected quantum bit and the frequency offset signal of the frequency of the selected quantum bit multiplied by a negative value, and outputs a frequency modulation signal based on the acquired frequency offset signal.

7. The quantum computer according to claim 2, further comprising:

   phase correction data that corrects the frequency shift of the plurality of quantum bits in the quantum bit array,

wherein the frequency generator outputs a sine wave based on the phase correction data of the selected quantum bit.

8. The quantum computer according to claim 2,
   wherein the converter is an RFDAC.

9. The quantum computer according to claim 2,
   wherein the converters comprises

   a DAC that converts the pulse data into an analog signal, and
   a mixer that modulates the analog signal with the sine wave and outputs a signal having the frequency of the sine wave as the center frequency as a microwave pulse.

10. A quantum computer, comprising:

    a quantum bit array with multiple quantum bits,
    a quantum bit selector that selects a quantum bit to be quantum manipulated from the quantum bit array and shifts the angular frequency, and
    a microwave pulse generator that has the same frequency as the selected quantum bit and outputs a microwave pulse with a set pulse width and pulse amplitude,
    wherein the microwave pulse generator comprises,
    a logic circuit that generates cosine and sine waves with set phase and frequency, multiplies them by pulses of the set pulse width and pulse amplitude, respectively, and outputs I modulation data and Q modulation data, respectively,
    a DAC that converts the I modulation data and Q modulation data from digital data to analog and outputs I modulation signal and Q modulation signal,
    a frequency generator that generates LO output sine waves and LO output cosine waves with a phase difference of 90° from each other with the frequency set by the frequency setting signal,
    an IQ modulator that multiplies the I modulation signal and the Q modulation signal with the LO output sine wave and the LO output cosine wave, respectively, and outputs a phase modulated microwave pulse, and
    a frequency divider that outputs a system clock divided by the output frequency of the frequency generator,
    wherein the frequency generator operates at the same frequency as the quantum bit other than the selected quantum bit except when the microwave pulse is output, and
    the logic circuit operates in synchronization with the system clock.

11. The quantum computer according to claim 10, further comprising:

    an IQ demodulator that multiplies the microwave pulse with the LO output sine wave and the LO output cosine wave and demodulates it into I demodulation signal and Q demodulation signal,
    an ADC that converts the I demodulation signal and the Q demodulation signal from analog to digital data and outputs I demodulation data and Q demodulation data, and
    a calibration circuit that acquires the I demodulation data and Q demodulation data, calculates the IQ gain error and phase error, and outputs the IQ correction data to the logic circuit,
    wherein the logic circuit corrects the cosine and sine waves using the IQ correction data.

12. A microwave pulse generator that outputs a microwave pulse that quantum manipulates a quantum bit selected from a quantum bit array and shifted in angular frequency, comprising:

    a logic circuit that outputs pulse data with a set pulse width and amplitude,
    a frequency generator that outputs a sine wave having the same frequency as the selected quantum bit,
    a converter that converts the pulse data into an analog signal, modulates it with the sine wave, and outputs a signal having the frequency of the sine wave as the center frequency as a microwave pulse, and
    a frequency divider that outputs a system clock divided by the frequency of the sine wave,
    wherein the frequency generator operates at the same frequency as the quantum bit other than the selected quantum bit except when the microwave pulse is output, and
    the logic circuit operates in synchronization with the system clock.

13. The microwave pulse generator according to claim 12,

wherein the logic circuit outputs a frequency modulation signal based on the frequency of the selected quantum bit, and
the frequency generator outputs a sine wave based on the frequency modulation signal.

14. The microwave pulse generator according to claim 13,
wherein the logic circuit calculates the amount of phase shift based on the set pulse width and the selected quantum bit frequency, and outputs a frequency modulation signal based on the amount of phase shift.

15. The microwave pulse generator according to claim 13,
wherein the logic circuit outputs a frequency modulation signal based on the frequency of the selected quantum bit, and then outputs a frequency modulation signal based on the frequency of the selected quantum bit multiplied by a negative value.

FIG.1

# FIG.2

101

EP 4 462 318 A2

FIG.3

EP 4 462 318 A2

FIG.4

203

114
115
116
117
118
124

401
402
403
404
405
406
407
411
412

213
214

1-Z⁻¹

FIG.5

pulse trigger signal 114

frequency offset 411

gain adjustment output 412

frequency modulation signal 214

output relative phase 501

microwave pulse 111

# FIG.6

gain adjustment
output412

Frequency
modulation
signal214

output frequency
601

output relative
phase501

FIG.7

FIG.8

pulse trigger signal114

frequency offset setting signal118

frequency offset signal711

frequency offset positive/negative signal712

frequency modulation signal214

output relative phase801

FIG.9

203

# FIG.10

EP 4 462 318 A2

# FIG.11

EP 4 462 318 A2

FIG.12

EP 4 462 318 A2

# FIG.13

EP 4 462 318 A2

FIG.14

# FIG.15

pulse trigger signal114

phase1411

phase data1412

cosine wave data1413

sine wave data1414

pulse waveform data1415

I modulation data1311

Q modulation data1312

EP 4 462 318 A2

FIG.16

# FIG.17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20180013426 A

- US 20200034736 A